# EUROPÄISCHE PATENTANMELDUNG

(11) **EP 2 469 991 A2**
(43) Veröffentlichungstag der Anmeldung: **27.06.2012**
(21) Anmeldenummer: 11195268.5
(22) Anmeldetag: 22.12.2011
(51) Int. Cl.: H05K 1/18, H05K 3/00, H05K 3/12

(54) **Etikett mit einem elektronischen Funktionselement**

(30) Priorität: 23.12.2010 DE 102010056055
(71) Anmelder: Schreiner Group GmbH & Co. KG, 85764 Oberschleissheim (DE)
(72) Erfinder: Schreiner, Helmut, 80995 München (DE)
(74) Vertreter: Epping - Hermann - Fischer

(57) **Zusammenfassung**

Beschrieben wird ein elektronisches Funktionsetikett und ein spezieller Herstellungsprozess für ein solches Etikett. Das Etikett kann dabei ohne einen mit hohen Temperaturen verbunden Lötprozess auf sehr einfache, schnelle und effektive Weise mit elektronischen Bauelementen bestückt werden. Dazu wird ein Trägersubstrat mit vorzugsweise gedruckten elektronischen Strukturen mittels eines elektrisch leitfähigen Klebstoffes mit elektronischen Bauelementen bestückt. Besonders vorteilhaft erweist sich in diesem Zusammenhang der Einsatz von speziellen elektronischen Bauelementen (Sensoren und optischen/akustischen Aktoren), die mit ihrer Umwelt interagieren. Auf diese Weise können besonders hochwertige Etiketten mit überraschenden Interaktionen einfach und kostengünstig hergestellt werden.

## Beschreibung

Die vorliegende Erfindung betrifft ein Etikett mit einer elektronischen Funktionskomponente, dessen Herstellung sowie einen mit einem solchen Etikett versehenen Gegenstand. Insbesondere betrifft die vorliegende Erfindung ein Folienetikett mit einer speziellen elektronischen Zusatzfunktion, das besonders einfach auf einen Gegenstand mit einer nahezu beliebig geformten Oberfläche aufgeklebt werden kann, sowie ein Herstellverfahren für ein solches Etikett.

Etiketten werden heutzutage vermehrt auch als Designelemente eingesetzt. Durch das Anbringen ansprechender Etiketten können gerade höherwertige Produkte noch zusätzlich optisch aufgewertet werden. Somit kann auf relativ einfache Weise ein zusätzlicher Kaufanreiz geboten werden.

Ferner ist es durch die Verwendung von Selbstklebeetiketten auch relativ einfach möglich, ein und demselben Produkt durch Anbringen von unterschiedlich gestalteten Etiketten ein unterschiedliches Aussehen zu verleihen. Damit ist es möglich, ein Produkt auch für unterschiedliche Zielgruppen attraktiv zu gestalten. Bereits hierdurch wird deutlich, dass Selbstklebeetiketten auch im Bereich des Marketings und des Designs ein hoher Stellenwert zukommt.

Darüber hinaus werden in jüngster Zeit auch immer öfter Etiketten mit speziellen Zusatzfunktionen ausgestattet. Dadurch ist eine weitere, zusätzliche Aufwertung der Produkte möglich. Beispielsweise kann durch eine Etikett mit einem Sensor-oder Indikatorelement, das Auftreten bestimmter Umwelteinflüsse, wie beispielsweise erhöhte Feuchtigkeit oder bestimmte Temperaturschwankungen, detektiert und angezeigt werden.

Solche Etiketten, die neben einem graphischen Aufdruck auch noch zusätzlich elektronische Zusatzfunktionen bereitstellen, erfordern jedoch einen wesentlich komplexeren Aufbau und unterliegen daher einem deutlich aufwändigeren Herstellungsprozess. Dabei kommt erschwerend hinzu, dass für die elektronischen Funktionen Komponenten erforderlich sind, die eine wesentlich größere Bauhöhe (einige Millimeter) besitzen als die reine Dicke der Trägerfolie eines Etiketts (einige Mikrometer).

Zwar schreitet die Miniaturisierung elektronischer Bauteile immer mehr voran, doch auch die kleinsten, heute erhältlichen Surface Mounted Devices (SMD) weisen im Vergleich zu der Dicke eines gewöhnlichen Etiketts eine wesentlich größere Bauhöhe auf. Dies hat unter anderem zur Konsequenz, dass solche Etiketten mit elektronischen Funktionselementen nicht mit den ansonsten üblichen Produktionseinrichtungen gefertigt werden können.

Flexible Folien mit aufgebrachten Leiterbahnen sind zum Beispiel aus US 2009/0314523 A bekannt. Dabei wird eine Trägerfolie aus Polyimid (PI) auf einer oder auch beiden Seiten mit Leiterbahnen aus Kupfer versehen. In der Regel wird hierzu aus einer vollflächigen Kupferfolie eine Leiterbahnstruktur herausgeätzt. Die Kontaktierung und Befestigung von elektronischen Bauteilen erfolgt bei einem solchen Aufbau, indem die einzelnen Bauteile auf der Kupferfolie verlötet werden, was entsprechend hohe Temperaturen während des Lötvorgangs zur Folge hat.

Aufgrund dieser hohen Temperaturen beim Löten werden an die Trägerfolie für solche Aufbauten besondere Anforderungen gestellt. Dies schränkt die Auswahl für mögliche Materialien sehr stark ein. In der Praxis hat sich als Trägermaterial für flexible Trägerstrukturen Polyimid (Handelsname "Kapton") bewährt. Dieses Material ist auch bei hohen Temperaturen noch sehr beständig, was besonders beim Löten unbedingt erforderlich ist.

Andererseits ist dieses Material auch sehr teuer. Darüber hinaus besitzt eine Folie aus Polyimid auch stets eine gelbliche Farbe, was gerade bei dem Einsatz von Etiketten, die in der Regel auch einen hohen optischen Anspruch besitzen, als großer Nachteil anzusehen ist. Ferner ist das Material auch relativ brüchig und kann daher nur bedingt auf stark gekrümmten oder gewölbten Oberflächen aufgeklebt werden. Außerdem ist diese geringe Flexibilität auch von Nachteil, wenn ein solches Foliensubstrat möglichst eng auf eine Rolle aufgewickelt werden soll, um in einem Rolle-zu-Rolle-Prozess verarbeitet werden zu können.

Es ist daher eine Aufgabe der vorliegenden Erfindung einen Folienaufbau anzugeben, bei dem auf preisgünstige und effiziente Art ein optisch anspruchsvolles Etikett mit elektronischen Funktionselementen ausgestaltet werden kann. Dafür ist es wünschenswert, Trägermaterialien für Etiketten verwenden zu können, die sich bereits in diesem Bereich etabliert haben und daher auf kostengünstige Weise so verarbeitet werden können und die auch den optischen und gestalterischen Ansprüchen an hochwertige Etiketten genügen. Dabei sollen solche Materialien auf möglichst einfache Art und Weise zusätzlich mit elektronischen Funktionselementen ausgerüstet werden, ohne dass dabei erhebliche Zusatzkosten für weitere Fertigungsschritte entstehen. Dabei ist die Verarbeitung und Bestückung eines erfindungsgemäßen Etikettes in einem Roller-zu-Rolle-Prozess wünschenswert.

Diese Aufgabe wird durch ein Folienelement mit einer elektronischen Funktionskomponente gelöst. Das Folienelement umfasst eine Trägerfolie mit einer ersten und einer zweiten Seite, mindestens eine elektrisch leitfähige Struktur, die durch Aufbringen einer elektrisch leitfähigen Druckfarbe auf die erste Seite der Trägerfolie aufgedruckt ist, ein elektronisches Bauelement, das auf die erste Seite der Trägerfolie aufgebracht ist, und einen elektrisch leitfähigen Klebstoff der mindestens einen Anschlusskontakt des elektronischen Bauelement mit der elektrisch leitfähigen Struktur verbindet.

Ferner wird diese Aufgabe auch durch ein Verfahren zur Herstellung eines solchen Folienelements mit einer elektrischen Funktionskomponente gelöst. Dieses Verfahren stellt eine Trägerfolie mit einer elektrisch leitfähigen Struktur bereit, wobei die elektrisch leitfähige Struktur aus einem im Druckverfahren aufgebrachten Leitlack hergestellt wurde. Auf die Trägerfolie mit der elektrisch leitfähigen Struktur wird partiell ein elektrisch leitfähiger Klebstoff aufgebracht. Ferner wird auf die Trägerfolie mindestens ein elektronisches Bauelement aufgespendet, wobei durch den elektrisch leitfähigen Klebstoff eine elektrisch leitfähige Verbindung zwischen der elektrisch leitfähigen Struktur auf der Trägerfolie und mindestens einem Anschluss des elektronischen Bauelements hergestellt wird.

Es ist der besondere Ansatz der vorliegenden Erfindung, einen Aufbau für ein elektronisches Funktionsetikett vorzuschlagen, bei dem optisch ansprechende, kostengünstige Standardfolienmaterialien in einem einfachen und effizienten Verfahren mit elektronischen Funktionselementen ausgestattet werden können. Dazu wird ein Trägersubstrat die vorzugsweise in einem Rolle-zu-Rolle-Verfahren verarbeitet werden kann unter Zuhilfenahme von elektrisch leitfähigen Klebstoffen mit elektronischen Bauelementen bestückt. Durch geeignete Auswahl der verwendeten elektronischen Bauelemente lässt sich so ein ansprechendes und komplexes Etikett erzeugen, das für zahlreiche Anwendungsfälle einen hervorragenden Zusatznutzen mit sich bringt.

In einer speziellen Ausführungsform wird die Trägerfolie mit der elektrisch leitfähigen Struktur als Folienbahn auf einer Rolle bereitgestellt. Somit kann die Trägerfolie für einen effizienten Verarbeitungsprozess auf besonders einfache Weise bereitgestellt werden. Die Trägerfolie für die einzelnen Etiketten wird dann zunächst von der Rolle abgewickelt, danach gemäß dem vorgeschlagenen Verfahren bestückt und kann anschließend zusammen mit den aufgespendeten Bauelementen auch wieder auf einer Rolle aufgerollt werden. Somit kann der komplette Bestückungsprozess sehr effektiv in einem Rolle-zu-Rolle-Prozess durchgeführt werden, wie es gerade im Druck- und Etikettenbereich gängige Praxis ist.

Alternativ zum Aufrollen der bestückten Etiketten können die einzelnen bestückten Folienelemente mit den aufgespendeten Bauelementen auch in einem Vereinzelungsschritt von der zusammenhängenden Folienbahn abgetrennt werden und liegen dann als einzelne, separate fertige elektronische Funktionsetiketten vor.

Gemäß einer speziellen Ausführungsform dieses Verfahrens wird der elektrisch leitfähige Klebstoff in einem gesonderten Schritt aktiviert und/oder ausgehärtet. Somit erfolgt nach dem Bestücken der Etikettenfolie mit den elektronischen Bauelementen ein sehr rascher Prozess, in dem die volle Klebewirkung des verwendeten Klebstoffes erreicht wird. Dabei kann es erforderlich sein, dass während des Aushärtens des Klebstoffes die elektronischen Bauelemente auf der Trägerfolie mechanisch fixiert werden müssen.

Zusätzlich kann in einem weiteren Verfahrensschritt auf mindestens einer Seite der Trägerfolie zumindest partiell ein Klebstoff aufgetragen werden, vorzugsweise ein Haftklebstoff. Somit erhält man ein vollständiges selbst lebendes Portionsetikett, das auf einfache Weise auf ein nahezu beliebiges Objekt aufgeklebt werden kann.

Vorzugsweise besitzt die Trägerfolie eine erste Dicke und das elektronische Bauteile eine zweite Dicke, wobei die zweite Dicke des elektronischen Bauteils größer ist als die erste Dicke der Trägerfolie. Während die Trägerfolie in der Regel aus einem sehr dünnen Substrat besteht, handelt es sich bei den elektronischen Bauteilen eher um Elemente mit einer Dicke von einem mit mehreren Millimetern, die einen deutlichen dreidimensionalen Charakter besitzen.

In speziellen Ausführungsformen umfasst das elektronische Bauteil vorzugsweise eine Batterie. Auch kann das Folienelement mit einer Elektrolumineszenzfolie ausgestattet werden. Ferner ist es möglich als elektronisches Bauteil einen Lautsprecher oder einen akustischen Signalgeber zu integrieren, so dass das elektronische Funktionsetikett entsprechende Signale an die Umwelt aussendet und somit besondere Aufmerksamkeit auf sich zieht.

Vorzugsweise kann das elektronische Funktionsetikett auch mit einem Sensor, beispielsweise einem Bewegungssensor ausgestattet werden. Somit können Umgebungseinflüsse, wie beispielsweise eine Annäherung einer Person, oder das Vorhandensein einer bestimmten Substanz detektiert werden. Ferner kann das Folienelement auch ein Schaltelement, beispielsweise einen mechanischen oder auch einen elektronischen Schalter umfassen. Ferner ist es auch möglich einen Chip oder einen integrierten Schaltkreis als elektronisches Bauteil auf dem Folienelement anzubringen.

Als besonders vorteilhaft hatte sich herausgestellt als Substrat für die Trägerfolie eines der Materialien Polyethylenterephthalat, Polyethylennaphthalat, Polyetherimid, Polyethersulfon, Acrylat oder Polyetheretherketon zu verwenden.

In einer weiteren bevorzugten Ausführungsform wird das Folienelement auf einen Gegenstand aufgebracht, wobei sich mindestens ein elektronisches Bauelement auf der den Gegenstand zugewandten Seite des Folienelement befindet. Damit sind die elektronischen Funktionsbauteile des Etiketts vor Umwelteinflüssen und Beschädigungen geschützt. Vorzugsweise besitzt der Gegenstand, auf den das Funktionsetikett aufgebracht ist, eine Vertiefung und das Folienteil ist so auf den Gegenstand angebracht, dass mindestens ein elektronisches Bauelement in dieser Vertiefung zu liegen kommt. Damit werden durch diese Vertiefung die dickeren Teile der elektronischen Bauelemente aufgenommen und nach außen hin bildet das Etikett trotz der die elektronischen Bauteile mit dreidimensionalem Charakter eine glatte Oberfläche ohne Erhebungen.

Im Folgenden werden die speziellen Ausführungsformen der vorliegenden Erfindung anhand der beiliegenden Figuren beschrieben. Es zeigen:
Figur 1 zeigt schematisch einen Querschnitt durch einen erfindungsgemäßen Etikettenaufbau,
Figur 2 zeigt schematisch einen Aufbau eines erfindungsgemäßen Funktionsetiketts mit mehreren Bauteilen,
Figur 3 zeigt schematisch ein erfindungsgemäßes Etikett, das auf einem Gegenstand angebracht ist,
Figur 4 zeigt schematisch ein erfindungsgemäßes Funktionsetikett mit einer Elektrolumineszensfolie, und
Figur 5 zeigt schematisch einen Produktionsprozess für ein erfindungsgemäßes Funktionsetikett in einem Rolle-zu-Rolle-Prozess.

Die folgende Beschreibung erläutert das elektronische Funktionsetikett, sowie seine Herstellung und Verwendung. Dabei sind die erfindungsgemäßen Gedanken nicht auf die beschriebenen Ausführungsbeispiele beschränkt. Weitere Ausgestaltungsformen die dem Grundprinzip dieser Erfindung zu Grunde liegende sind ebenso möglich.

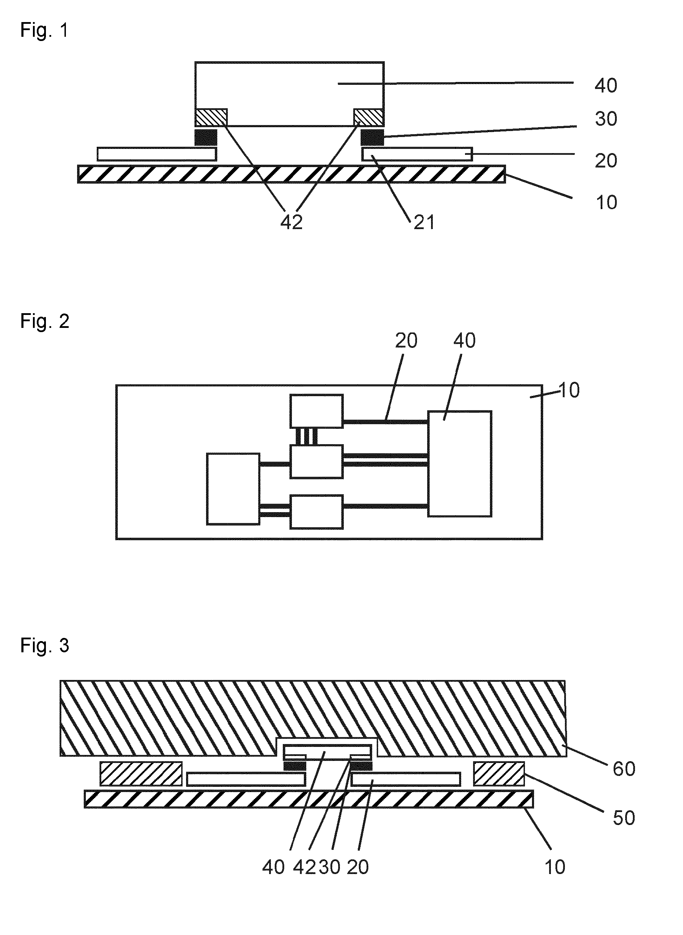

Figur 1 zeigt eine erste Ausführungsform eines erfindungsgemäßen Folienaufbaus 1. Auf einem Foliensubstrat 10 sind zunächst elektrisch leitfähige Strukturen 20 aufgebracht. Vorzugsweise werden diese elektrisch leitfähigen Strukturen 20 durch Aufbringen eines elektrisch leitfähigen Lacks im Druckverfahren hergestellt. Beispielsweise könnte als elektrisch leitfähiger Lack eine Silberleitpaste, Carbon Black, eine organische Leitpaste oder eine andere Substanz mit leitfähigen Partikeln verwendet werden.

Alternative Verfahren zum Aufbringen elektrisch leitfähiger Strukturen auf das Trägersubstrat 10 sind jedoch ebenfalls möglich. Beispielsweise kann auch eine Kupferfolie, eine ITO-Beschichtung oder ein anderer leitfähiger Streifen aufkaschiert werden. Zur Befestigung und gleichzeitigen elektrischen Kontaktierung des elektrischen Bauelements 40 wird an den Kontaktstellen 21 der Leiterbahnen 20 ein elektrisch leitfähiger Klebstoff 30 aufgebracht. Der Klebstoffauftrag kann dabei in einem Druckverfahren erfolgen, als Klebeband aufkaschiert werden, oder auch anderweitig appliziert werden. Das elektronische Bauelement 40 umfasst Anschlusskontakte 42, die den leitfähigen Klebstoff 30 kontaktieren. Dadurch ist eine elektrische Verbindung zwischen den Anschlusskontakten 42 des elektronischen Bauelements 40 und den elektrisch leitfähigen Strukturen 20 über den leitfähigen Klebstoff 30 und die Kontaktstellen 21 der Leiterbahnen 20 hergestellt.

Anschließend wird das elektronische Bauelement 40 an der gewünschten Stelle positioniert und der elektrisch leitfähige Klebstoff 30 ausgehärtet. Die Positionierung des Bauelements auf dem Trägersubstrat 10 erfolgt dabei mittels einer geeigneten speziellen Spendevorrichtung. Insbesondere kann das Bauteil aufkaschiert werden, oder per Pick-and-place-Verfahren auf die gewünschte Stelle positioniert werden.

Um ein solches Etikett möglichst einfach an einem beliebigen Objekt fixieren zu können, wird das Foliensubstrat 10 zumindest teilflächig noch mit einem Klebstoff 50, vorzugsweise einem Haftklebstoff, versehen. Diese Haftklebstoff 50 kann auf derselben Seite des Foliensubstrats 10 aufgebracht werden, auf der sich auch die Leiterbahnen 20 und die elektronischen Bauelemente 40 befinden. Alternativ kann der Haftklebstoff 50 auch auf der Seite des Foliensubstrats 10 aufgebracht werden, die den Leiterbahnen 20 und den elektronischen Bauelementen 40 gegenüberliegt.

Der aufgebrachte Klebstoff 50 kann zusätzlich noch mit einer Schutzfolie, einem sogenannten Liner, abgedeckt werden. Auch ist es möglich ein Decklaminat auf dem bestückten Funktionsetikett anzubringen. Außerdem bietet es sich auch an, dass mit dem Klebstoff 50 beschichtete Etikett an einem Randbereich mit einer klebstofffreien Anfass- bzw. Abziehlasche zu versehen.

Als Materialien für das Substrat der Trägerfolie 10 kommen vorzugsweise Kunststoffe zum Einsatz, die eine gute Flexibilität aufweisen. Gut geeignet sind dabei Substrate aus transparenten oder weißen Materialien. Als geeignete Materialien haben sich zum Beispiel Polyethylen-Terephthalat (PET) als besonders kostengünstige Lösung oder Polyethylen-Naphthalat (PEN) mit einer etwas höheren Temperaturstabilität erwiesen. Selbstverständlich sind auch nahezu alle anderen gebräuchlichen Kunststofffolien als Trägersubstanz für den erfindungsgemäßen Folienaufbau denkbar. Weitere besonders geeignete Materialien sind zum Beispiel Polyetherimid (PEI), Polyethersulfon (PU), Polycarbonat (PC), Acrylat oder Polyetheretherketon (PEEK).

Im Gegensatz zu den konventionellen bisher bekannten einsetzbare Materialien wie Polyimid und dergleichen, die aufgrund des konventionellen Lötprozessen und den damit verbundenen relativ hohen Temperaturen eingesetzt werden mussten, sind die hier verwendeten Materialien deutlich kostengünstiger und besitzen bezüglich Flexibilität und optischem Erscheinungsbild wesentlich bessere Eigenschaften.

Ein besonders guter optischer Eindruck eines erfindungsgemäßen Etiketts kann auch dadurch erreicht werden, dass die Trägerfolie 10 zumindest auf einer Seite mit einem Decklack beschichtet wird. Vorzugsweis wird dieser Decklack auf der Seite aufgetragen, die der Seite mit den Leiterbahnen 20 gegenüberliegt. Zusätzlich oder alternativ kann die Trägerfolie 10 mit Schriftzeichen, Symbolen oder Dekorelementen versehen werden. Beispielsweise können solche optischen Gestaltungselemente in einem Druckverfahren aufgebracht werden. Ganz besonders attraktive Effekte lasen sich auch durch zusätzliches Aufbringen sogenannter Lentikularfolien (3D-/4D-Folien) auf dem Etikett erzielen. Weitere Beschichtungen insbesondere zur Steigerung des optischen Erscheinungsbildes, oder auch andere Verfahren zur Gestaltung des Folienaufbaus sind ebenso möglich.

Figur 2 zeigt die Draufsicht eines erfindungsgemäßen Etikettenaufbaus. Dabei sind mehrere elektronische Bauelemente 40 über Leiterbahnen 20 miteinander verbunden und bilden so einen vollständigen elektronischen Schaltungsaufbau.

Bei den einzelnen Bauelementen kann es sich dabei beispielsweise um eine Energieversorgung, wie eine Batterie handeln. Zur Energieversorgung kann auch ein Photovoltaikelement, eine so genannte Solarzelle eingesetzt werden. Insbesondere in Verbindung mit einem relativ kleinen weiteren Energiespeicher, wie beispielsweise einem Kondensator oder einem Akkumulator erhält man so über lange Zeit auf kleinstem Raum eine ausgezeichnete Energieversorgung.

Auch Schaltelemente, wie zum Beispiel ein Folienschalter sind möglich. Ferner können für eine Eingabe auch zum Beispiel Sensorelemente, wie ein kapazitives Sensorelement oder Ähnliches zum Einsatz kommen. Auch elektronische Ausgabeelemente, wie beispielsweise ein Lautsprecher oder Summer sind ebenso denkbar wie optische Anzeigeelemente, beispielsweise eine LED, eine Elektrolumineszenzfolie, ein organisches Leuchtelemente oder Ähnliches. Ferner kann der Folienaufbau auch einzelne diskrete elektronische Bauelemente, wie zum Beispiel Widerstände, Kondensatoren, Spulen, etc. umfassen. Darüber hinaus sind auch integrierte Schaltkreise, komplette Mikrocontroller oder vorgefertigte und ggf. vergossene Baugruppen möglich.

Alle diese elektronischen Bauelemente 40 haben jedoch die Eigenschaft, dass sie eine geringfügig bis zum Teil erheblich größere Dicke besitzen, als die Trägerfolie 10. Während die Trägerfolie eine Dicke von weniger als 1 mm besitzt, oft sogar nur wenige Mikrometer, besitzen elektronische Bauteile, auch in einer miniaturisierten Ausführung eine im Vergleich zur Trägerfolie 10 deutlich größere Dicke von ca. einem bis einigen Millimetern. Im Vergleich zu der geringen Dicke der Trägerfolie 10 haben solche elektronische Bauteile daher einen dreidimensionalen Charakter.

Da für die Verbindung und Kontaktierung der elektronischen Bauelemente kein Löten erforderlich ist, sondern dieser Prozess mittels eines elektrisch leitfähige Klebstoffs erfolgt, werden die Bauelemente 40 und auch das Trägersubstrat 10 keinen hohen Temperaturen ausgesetzt. Damit werden die zum Einsatz kommenden Elemente und Materialien erheblich geschont.

Figur 3 zeigt ein erfindungsgemäßes Etikett, das auf einen Gegenstand 60 aufgeklebt ist. Auch wenn der Etikettenaufbau über weite Teile eine relativ konstante Dicke aufweist, so ist doch gerade im Bereich zumindest einiger elektronischer Bauelemente die Dicke größer. Vorzugsweise kommt dieser etwas dickere Etikettenbereich in einer kleinen Vertiefung des zu etikettierenden Gegenstands 60 zu liegen. So kann nach außen ein glattes und homogenes Erscheinungsbild gewährleistet werden.

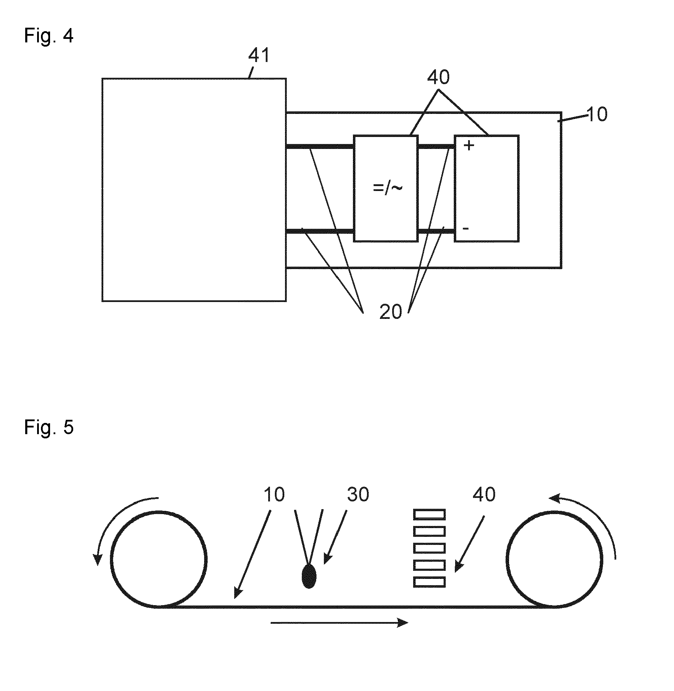

Figur 4 zeigt einen erfindungsgemäßen Etikettenaufbau, an dessen einen Seite eine Elektrolumineszenzfolie 41 angebracht ist. Die Kontaktierung dieser EL-Folie 41 kann dabei genauso mittels eines elektrisch leitfähigen Klebstoffes erfolgen, wie er auch bei den übrigen Bauelementen 40 zum Einsatz kommt.

Darüber hinaus ist es ebenso denkbar, dass der EL-Folienaufbau und das übrige Etikett ein gemeinsames Trägersubstrat 10 besitzen und somit zwischen den beiden Teilen keine klebende Verbindung erforderlich ist.

Basierend auf dem oben beschriebenen erfindungsgemäßen Folienaufbau ergeben sich je nach verwendeten elektronischen Bauelementen 40 ganz besondere Eigenschaften und Vorteile. Beispielsweise können als elektronische Bauelemente 40 auch Umweltsensoren eingesetzt werden. So kann je nach Verwendung eines geeigneten Sensorelements ein entsprechendes Ereignis zunächst detektiert und bei Bedarf gegebenenfalls gespeichert und / oder angezeigt werden. Beispielsweise könnte ein Temperatursensor bei Über- oder Unterschreiben einer vorgegebenen Temperaturschwelle ansprechen und ein Signal aussenden. Aber auch weitere Sensoren, die auf den Luft- oder Umgebungsdruck reagieren sind ebenso denkbar wie spezielle Sensoren, die auf das Auftreten einer bestimmten Substanz, beispielsweise eines Gases oder einer Flüssigkeit, wie zum Beispiel Wasser reagieren.

Beim Ansprechen eines der oben beschriebenen Sensoren könnte ein integrierter Schaltkreis dieses Ereignis zusammen mit einem entsprechenden Zeitstempel speichern und für eine spätere Auswertung bereitstellen. Es kann zusätzlich auf dem Etikett auch noch ein RFID-Transponder mit integriert werden, so dass darüber berührungslos ein Ereignisprotokoll der verwendeten Sensoren ausgelesen werden kann. Damit stellt ein solches Etikett gerade im Logistikbereich eine wertvolle Hilfe da, wenn es darum geht, sensible Waren während eines Transportvorgangs zu schützen und unerwünschte Einflüsse zu erkennen. Unstimmigkeiten während eines Transport- oder Lagervorgangs können so rasch identifiziert werden und eine gegebenenfalls beschädigte Ware kann damit rechtzeitig erkannt und aussortiert werden.

Ferner ist es auch ebenso möglich als einen Sensor einen Bewegungsmelder in den Etikettenaufbau zu integrieren. Solche Bewegungssensoren nehmen in der Regel Veränderungen im Infrarotbereich ihrer Umgebung wahr und geben daraufhin ein entsprechendes Schaltsignal weiter. Wenn ein Bewegungssensor mit in den Etikettenaufbau integriert wird, so ist es zum Beispiel möglich, eine spezielle Aktion auszulösen, sobald eine Person an dem Etikett vorbei läuft oder sich nähert. Beispielsweise könnte ein Leuchtelement (z.B. eine EL-Folie) zu leuchten beginnen, oder es ertönt aus einem Lautsprecher des Etiketts ein Signalton oder eine Melodie.

Ein solches elektronisches Funktionsetikett ist somit in der Lage, auf eine vorbeigehende Person zu reagieren und durch Ausgabe entsprechender optischer und akustischer Signale die Aufmerksamkeit auf sich zu ziehen. Damit können gerade im Bereich der Werbung besonders attraktive Effekte erzielt werden, um damit ein bestimmtes Produkt ganz besonders in den Mittelpunkt zu setzen. Besonders vorteilhaft erweist sich in diesem Zusammenhang, dass ein erfindungsgemäßes Etikett auch zu einem späteren Zeitpunkt nachträglich noch auf ein Produkt aufgebracht werden kann und somit dieses Produkt aufwertet.

In der Regel befindet sich der Schaltungsaufbau mit den Leiterbahnen und den Sensoren dabei auf der "Unterseite" des Etiketts. D.h. ein Etikett wird so auf einen Gegenstand 60 aufgeklebt, dass die Leiterbahnen und die elektronischen Bauelemente sich zwischen dem Gegenstand und der Trägerfolie befinden. Damit sind die Sensoren zunächst von der Außenwelt durch die Trägerfolie 10 abgeschirmt. Gerade bei der Verwendung von Sensoren kann es von Vorteil sein, wenn die Trägerfolie 10 daher spezielle Öffnungen besitzt, durch die ein Sensor mit der äußeren Umwelt in Kontakt treten kann und entsprechende Umwelteinflüsse wahrnehmen kann. Solche Öffnungen können beispielsweise auf einfache Weise dadurch hergestellt werden, dass eine entsprechende, geeignete Öffnung in die Trägerfolie 10 hineingestanzt wird.

Für aufwändigere oder komplexere Schaltungsaufbauten kann es darüber hinaus auch erforderlich sein, auf beiden Seiten der Trägerfolie 10 Leiterbahnen 20 anzubringen. Diese Leiterbahnen können auf beiden Seiten aufgedruckt oder auf andere Weise angebracht werden, so dass auf diese Weise auch komplexere Leiterbahnenstrukturen realisiert werden können. Eine Verbindung zwischen den Leiterbahnen der beiden Seiten kann beispielsweise dadurch hergestellt werden, dass in die Trägerfolie 10 kleine Öffnungen hineingestanzt werden. Diese Öffnungen können anschließend mit leitfähigem Lack gefüllt werden, der auch zum Drucken der Leiterbahnen 20 verwendet wird. Somit kann auf einfache Weise eine Durchkontaktierung zwischen den beiden Seiten der Trägerfolie 10 erfolgen.

Bei dem erfindungsgemäßen Folienaufbau hat es sich dabei als besonders vorteilhaft erwiesen, dass sich der beschriebene Etikettenaufbau in einem sehr einfachen Prozessverfahren herstellen lässt. Figur 5 zeigt eine Ausführungsform eines Produktionsverfahrens, wie erfindungsgemäße Etiketten hergestellt werden können.

Das Trägersubstrat 10 wird hierfür zunächst in einem Rolle-zu-Rolle-Prozess mit den elektrisch leitfähigen Strukturen beschichtet. Beispielsweise wird in einem Druckverfahren, vorzugsweise im Siebdruck, ein elektrisch leitfähiger Lack auf das Trägersubstrat 10 aufgedruckt. Anschließend wird der Lack getrocknet bzw. ausgehärtet. Danach wird das Trägersubstrat 10 wieder auf eine Rolle aufgewickelt und steht für eine Bestückung mit elektronischen Bauteilen zur Verfügung.

In einem weiteren Prozessschritt wird das so vorbereitete Trägersubstrat von der Rolle abgewickelt. An den Stellen 21, an denen die Bauelemente 40 mit den Leiterbahnen kontaktiert werden sollen, wird daraufhin elektrisch leitfähiger Klebstoff 30 auf die Leiterbahnkontakte 21 aufgebracht. Daraufhin wird in einem weiteren Verfahrensschritt eines oder mehrere Bauelemente 40 präzise auf das vorbereitete Trägersubstrat 10 mit dem Klebstoff 30 positioniert. Der Klebstoff 30 dient dabei einerseits als elektrischer Kontakt und gleichzeitig als Fixierung des Bauelements 40 auf dem Foliensubstrat. Anschließend muss gegebenenfalls das Bauelement 40 noch so lange mechanisch auf das Foliensubstrat 10 gedrückt werden, bis der Klebstoff ausreichend ausgehärtet ist. Bei Bedarf kann dieser Prozess des Aushärtens durch Zuführen von Wärme, und/oder Druck aktiviert oder beschleunigt werden. Andere Verfahren für die Aktivierung und Aushärtung des elektrisch leitfähigen Klebstoffes sind dabei ebenso möglich. Beispielsweise kann hierfür auch eine Bestrahlung mit UV-Licht, eine spezielle chemische Substanz oder ein anderes Verfahren zum Einsatz kommen.

Gegebenenfalls wird das so bestückte Foliensubstrat 10 noch zusätzlich mit einem Haftklebstoff 50 beschichtet und bei Bedarf wird der Haftklebstoff mit einer Schutzfolie abgedeckt. Somit erhält man ein selbstlebendes Etikett, welches auf einfache Weise mit einer elektronischen Funktionseigenschaft ausgestattet ist.

Bei Bedarf kann in dieser Prozesskette an einem geeigneten Punkt des Fertigungsprozesses auch noch ein weiterer Schritt integriert werden, in dem das Foliensubstrat einfarbig oder mehrfarbig bedruckt wird. Hierdurch erhält das Etikett neben seiner elektronischen Funktion auch noch eine hochwertige optische Erscheinung.

Zum Schutz der elektronischen Bauteile 40 und auch der Leiterbahnen 20 kann das fertig gestellte Funktionsetikett noch mit einem speziellen Schutzlack oder auch einem sehr flexiblen Schutzlaminat überzogen werden. Somit sind die relativ empfindlichen Bestandteil des Etiketts vor Beschädigungen geschützt und gleichzeitig wird die Elektronik des Etiketts auch vor einer Berührung durch einen Menschen geschützt.

Nachdem ein so von einer Rolle abgewickeltes Trägersubstrat 10 mit elektronischen Bauteilen 40 und gegebenenfalls weiteren Bestandteile bestückt wurde, kann es anschließend auf eine weitere Rolle aufgewickelt werden. So ist es möglich eine große Menge von fertig bestückten elektronischen Funktionsetiketten auf sehr komfortable Weise für einen nachfolgenden Spendeprozess bereitzustellen. Gerade aufgewickelte Etiketten bieten sich hervorragend für einen automatisierten Spendeprozess an, da somit auf komfortable Weise eine große Anzahl von Etiketten bereitgestellt werden können.

Alternativ ist es darüber hinaus auch möglich, die einzelnen Etiketten unmittelbar nach der Bestückung mit den elektronischen Bauteilen 40 und den gegebenenfalls noch weiter folgenden Prozessschritten zu vereinzeln, d.h. von der bisher zusammenhängenden Trägerfolie 10 wird jedes einzelne Etikett abgetrennt. Beispielsweise kann dies durch einen Stanzprozess erfolgen. Die einzelnen, fertiggestellten Funktionsetiketten liegen dann als separate Stücke vor. Unter dem Begriff stanzen ist dabei hier, wie auch in der gesamten übrigen Beschreibung sowohl ein Stanzen mit einer konventionellen Stanze, als auch ein Abtrennen mittels Laser ("Laserstanzen") oder auch andere gebräuchliche Verfahren zu verstehen.

Zusammenfassend beschreibt diese Erfindung ein elektronisches Funktionsetikett und einen speziellen Herstellungsprozess für ein solches Etikett. Das Etikett kann dabei ohne einen mit hohen Temperaturen verbundenen Lötprozess auf sehr einfache, schnelle und effektive Weise mit elektronischen Bauelementen bestückt werden. Dazu wird ein Trägersubstrat mit vorzugsweise gedruckten elektronischen Strukturen mittels eines elektrisch leitfähigen Klebstoffes mit elektronischen Bauelementen bestückt. Besonders vorteilhaft erweist sich in diesem Zusammenhang der Einsatz von speziellen elektronischen Bauelementen (Sensoren und optischen/akustischen Aktoren), die mit ihrer Umwelt interagieren. Auf diese Weise können besonders hochwertige Etiketten mit überraschenden Interaktionen einfachen kostengünstig hergestellt werden.

## Patentansprüche

1. Folienelement mit einer elektronischen Funktionskomponente, umfassend:
eine Trägerfolie (10) mit einer ersten Seite und einer zweiten Seite,
eine elektrisch leitfähige Struktur (20), die durch Aufbringen einer elektrisch leitfähigen Druckfarbe auf die erste Seite der Trägerfolie (10) aufgedruckt ist,
ein elektronisches Bauelement (40), das auf die erste Seite der Trägerfolie (10) aufgebracht ist, und
einen elektrisch leitfähigen Klebstoff (30), der mindestens einen Anschlusskontakt (21) des elektronischen Bauelements (40) mit der elektrisch leitfähigen Struktur (20) verbindet.

2. Folienelement nach Anspruch 1, wobei die Trägerfolie (10) eine erste Dicke besitzt und das elektronische Bauteil (40) eine zweite Dicke besitzt und wobei die zweite Dicke des elektronischen Bauteils (40) größer ist als die erste Dicke der Trägerfolie.

3. Folienelement nach Anspruch 1 oder 2, wobei das Folienelement ferner auf mindestens einer Seite mindestens partiell mit einem Klebstoff (50) versehen ist.

4. Folienelement nach einem der Ansprüche 1 bis 3, wobei das elektronische Bauteil (40) mindestens eine Batterie oder mindestens einen Lautsprecher oder einen akustischen Signalgeber oder mindestens einen Sensor oder mindestens einen Bewegungssensor oder mindestens einen integrierten Schaltkreis oder einen Chip umfasst.

5. Folienelement nach einem der Ansprüche 1 bis 4, wobei das Folienelement ferner eine Elektrolumineszenzfolie umfasst.

6. Folienelement nach einem der Ansprüche 1 bis 5, das ferner mindestens ein Schaltelement umfasst.

7. Folienelement nach einem der Ansprüche 1 bis 6, wobei die Trägerfolie (10) aus einem der Materialien Polyethylenterephthalat, Polyethylennaphthalat, Polyetherimid, Polyethersulfon, Polycarbonat, Acrylat oder Polyetheretherketon besteht.

8. Gegenstand mit einem Folienelement nach einem der Ansprüche 1 bis 7, wobei das Folienelement so auf dem Gegenstand (60) aufgebracht ist, dass sich mindestens ein elektronisches Bauelement (40) auf der dem Gegenstand (60) zugewandten Seite des Folienelements befindet.

9. Gegenstand nach Anspruch 8, wobei der Gegenstand (60) eine Vertiefung besitzt und das Folienteil so auf dem Gegenstand (60) angebracht ist, das mindestens ein elektronisches Bauelement in dieser Vertiefung zu liegen kommt.

10. Verfahren zur Herstellung eines Folienelements mit einer elektronischen Funktionskomponente, umfassend:
Bereitstellen einer Trägerfolie mit mindestens einer elektrisch leitfähigen Struktur, wobei die elektrisch leitfähige Struktur aus einem im Druckverfahren aufgebrachten Leitlack hergestellt wurde,
Partielles Aufbringen eines elektrisch leitfähigen Klebstoffs auf die Trägerfolie mit der elektrisch leitfähigen Struktur,
Aufspenden mindestens eines elektronischen Bauelements auf die Trägerfolie, wobei durch den elektrisch leitfähigen Klebstoff eine elektrisch leitfähige Verbindung zwischen der elektrisch leitfähigen Struktur auf der Trägerfolie und mindestens einem Anschlusskontakt des elektronischen Bauelements hergestellt wird.

11. Verfahren nach Anspruch 10, wobei die Trägerfolie als Folienbahn mit der elektrisch leitfähigen Struktur auf einer Rolle bereitgestellt wird.

12. Verfahren nach Anspruch 11, das ferner ein Aufrollen der Trägerfolie mit den aufgespendeten Bauelementen umfasst.

13. Verfahren nach Anspruch 11, das ferner ein Vereinzeln umfasst, bei dem ein Folienelement mit mindestens einem aufgespendetem Bauelement von der Folienbahn abgetrennt wird.

14. Verfahren nach einem der Ansprüche 10 bis 13, das ferner ein Aushärten des elektrisch leitfähigen Klebstoffs umfasst, wobei das Bauelement während des Aushärtens auf der Trägerfolie mechanisch fixiert wird.

15. Verfahren nach einem der Ansprüche 10 bis 14, das ein mindestens partielles Auftragen eines Klebstoffes auf die Trägerfolie umfasst.
